# EUROPÄISCHE PATENTSCHRIFT

(11) **EP 2 588 643 B1**
(45) Veröffentlichungstag und Bekanntmachung des Hinweises auf die Patenterteilung: **07.11.2018**
(21) Anmeldenummer: 11729082.5
(22) Anmeldetag: 20.06.2011
(51) Int. Cl.: C23C 18/12, H01L 21/02

(54) **MODIFIZIERUNG VON SILICIUMSCHICHTEN AUS SILAN-HALTIGEN FORMULIERUNGEN**
MODIFICATION OF SILICON LAYERS FORMED FROM SILANE-CONTAINING FORMULATIONS
MODIFICATION DE COUCHES DE SILICIUM FORMÉES À PARTIR DE FORMULATIONS CONTENANT DU SILANE

(30) Priorität: 30.06.2010 DE 102010030696
(43) Veröffentlichungstag der Anmeldung: 08.05.2013
(73) Patentinhaber: Evonik Degussa GmbH, 45128 Essen (DE)
(72) Erfinder: STÜTZEL, Bernhard, 45770 Marl (DE); FAHRNER, Wolfgang, 79194 Gundelfingen (DE)
(86) Internationale Anmeldenummer: PCT/EP2011/060206
(87) Internationale Veröffentlichungsnummer: WO 2012/000815

(56) Entgegenhaltungen:
- JP-A- 2005 178 363
- US-B1- 7 314 513
- PIVIN J C ET AL: "Exciton-erbium coupling in SiOx suboxide films prepared by combining sol-gel chemistry and ion implantation", MATERIALS SCIENCE AND ENGINEERING B, ELSEVIER SEQUOIA, LAUSANNE, CH, Bd. 97, Nr. 1, 15. Januar 2003 (2003-01-15), Seiten 13-19, XP004399808, ISSN: 0921-5107, DOI: 10.1016/S0921-5107(02)00389-6
- BELOT V ET AL: "Sol-gel route to silicon suboxides. Preparation and characterization of silicon sesquioxide", JOURNAL OF NON-CRYSTALLINE SOLIDS, NORTH-HOLLAND PHYSICS PUBLISHING. AMSTERDAM, NL, Bd. 127, Nr. 2, 1. Februar 1991 (1991-02-01), Seiten 207-214, XP024062925, ISSN: 0022-3093, DOI: 10.1016/0022-3093(91)90144-U [gefunden am 1991-02-01]
- T. MÜLLER ET AL.: "Application of Wide Band Hydrogenated Amorphous Silicon Oxide (a-SiOx:H) Layers to Heterojunction Solar Cells for High- Quality Passivation", 33RD IEEE PHOTOVOLTAIC SPECIALISTS CONFERENCE, 11. Mai 2008 (2008-05-11), XP002662198, in der Anmeldung erwähnt

## Beschreibung

Die Erfindung betrifft ein Verfahren zur Herstellung einer sauerstoffhaltigen Oberfläche oder Grenzfläche einer Siliziumschicht, die auf einem Substrat angeordnet ist, insbesondere bei der Herstellung photovoltaischer Geräte.

Die konventionelle Herstellung von Solarzellen besteht entweder in der Gegendotierung eines dotierten Halbleitersubstrates mittels Implantation oder Diffusion oder Abscheidung einer gegendotierten Halbleiterschicht auf einem dotierten Halbleitersubstrat mittels Epitaxie oder in der Abscheidung von Halbleiterschichten verschiedener Dotierung aus der Gasphase im Vakuum oder aus Varianten der genannten Verfahren. Der Nachteil aller dieser Verfahren ist der wirtschaftliche und preisliche Aufwand, der damit betrieben werden muss.

Zur Vermeidung der notwendigen Vakuumtechnik, hoher Temperaturen und/oder eines teuren Substrates versucht man, Schichten oder Schichtfolgen aus Silanen der Flüssigphase herzustellen.

Bei der Herstellung von Solarzellen benötigt man Halbleiterschichten unterschiedlicher Dotierung mit zumindest einem pn-Übergang. Durch Abscheiden einer oder mehrerer Schichten dieser Silane auf einem geeigneten Substrat kann ein oder mehrere p-n Übergänge erzeugt werden, die als Solarzelle wirken. Die Abscheidung erfolgt mittels einer für dünne Schichten geeigneten Auftragsvorrichtung, z. B. eines spin coaters. Die entstandenen Schichten werden durch eine geeignete Temperaturbehandlung stabilisiert, so dass sie typischerweise eine Mischung von mikrokristallinen, nanokristallinen und amorphen (kurz: polymorphen) Gefügen annehmen. Sofern nicht explizit ausgeführt, sollen hier alle mikrokristallinen, nanokristallinen und/oder amorphen Schichten allgemein als "polymorph" bezeichnet werden, da eine genaue Unterscheidung und Festlegung in den meisten Fällen nicht gut möglich ist bzw. für das erzielte Ergebnis von untergeordneter Bedeutung ist.

Wie man Siliciumschichten aus Silanen herstellt, ist an sich bekannt. So lehrt GB 2077710 die Herstellung von Polysilanen der allgemeinen Formel -(SiH₂)ₙ- mit n ≥10 durch gleichzeitige Reduktion und Polymerisation von SiH₂Cl₂ mit Alkalimetallen. Solche höheren Silane werden als Precursor für Siliziumschichten benannt, z. B. für Solarzellen. Im Falle der Silane SiₙH₂ₙ₊₂ mit kleineren Werten für n, nämlich n ≤4, lehrt JP 7267621 die Herstellung von Siliciumschichten aus Filmen solcher Silane, die zuerst bei tiefen Temperaturen, in denen solche Silane einen niedrigen Dampfdruck haben, mit UV bestrahlt, und dann auf Temperaturen über 400°C erhitzt werden. Des Weiteren lehrt EP 1284306, dass man aus cyclischen Silanen der allgemeinen Formel SiₙH₂ₙ und offenkettigen Silanen der allgemeinen Formel SiₙH₂ₙ₊₂, jeweils mit n=3 bis 10, auf ähnliche Weise Silicium-Filme herstellen kann. Diese Silane werden dabei teilweise oder in Gänze oligomerisiert, z. B. durch Erhitzen und/oder UV-Bestrahlung. Außerdem werden spezielle Phosphor-Verbindungen bzw. Bor-Verbindungen zugegeben, um eine n- bzw. p-Dotierung zu erreichen.

Im Stand der Technik stellt man aus diesen Lösungen nacheinander jeweils n- bzw. p-dotierte Siliziumschichten her, indem man die Flüssigformulierung beispielsweise durch Spin-Coating auf geeignete leitfähige Substrate aufbringt und dann in Silizium umwandelt. Die Schritte sind
i) Bereitstellen eines Substrats,
ii) Bereitstellen einer Formulierung enthaltend mindestens eine Silizium- Verbindung und ggf. einer Phosphor- oder Bor-Verbindung,
iii) Beschichten des Substrats mit der Formulierung,
iv) Bestrahlen und/oder thermisches Behandeln des beschichteten Substrats unter Bildung einer zumindest teilweise polymorphen und überwiegend aus Silizium bestehenden Schicht.

Die so erhaltenen Siliziumschichten weisen typischerweise eine Mischung von mikrokristallinen, nanokristallinen und amorphen Gefügen auf. Schichten mit solchen Gefügen werden an dieser Stelle und im Folgenden "polymorph" genannt. Bei der oben geschilderten konventionellen Herstellung von Siliziumschichten tritt das Problem auf, dass bei den p-n Übergängen Verluste auftreten, die z. B. im Falle einer Solarzelle deren Wirkungsgrad herabsetzen. Die Ursache hierfür sind Störungen an der Silizium- Oberfläche bzw. Grenzfläche der unterschiedlich dotierten Siliziumschichten, welche die Rekombination von Ladungsträgern erhöhen. Im wohlbekannten Vergleichsfall von Heterojunction-Solarzellen (amorphes Silizium, aSi, auf mono- oder multikristallinem Silizium, (m)cSi), sind die Ursachen für die Reduzierung des Wirkungsgrades sowohl qualitativ als auch quantitativ bekannt (z. B. H. Angermann et al.: Optimisation of electronic interface properties of a-Si:H/c-Si hetero-junction solar cells by wetchemical surface pre-treatment, Proceedings on Advanced Materials and Concepts for Photovoltaics EMRS 2007 Conference, Strasbourg, France, Fahrner, W. R. et al.: Simulation of Interface States in a-Si:H/mc-Si Heterojunction Solar Cells, 17th Workshop on Crystalline Silicon Solar Cells & Modules: Materials and Processes, Vail, Colorado USA, August 5 -8 (2007). Als maßgeblicher störender Einfluss wirken Oberflächenzustände, die als Rekombinationszentren photogenerierte Nutzladungen vernichten und damit den Nutzstrom über den Verbraucherkreis verringern. Messtechnisch wird diese Vernichtung als erhöhte Oberflächenrekombinationsgeschwindigkeit erfasst. Auf folgenden Wegen versucht man dort, die Dangling Bonds (nicht abgesättigte Silizium-Bindungen) zu reduzieren bzw. die Oberflächeneigenschaften zu verbessern: (1) Es wird (atomarer) Wasserstoff eingetrieben, um diese freien Bindungen abzusättigen. Technisch erfolgt dies, indem z. B. bei einer PECVD-Abscheidung das Silan mit Wasserstoff verdünnt wird. Dieses Verfahren ist weitgehend erprobt und die Chancen auf eine weitergehende Verbesserung werden als gering angesehen. (2) Es wird eine dielektrische Schicht deponiert. Aufgrund ihres hohen Widerstandes kann diese Schicht nicht zwischen a-Si und c-Si eingebaut werden, sondern nur auf der Absorberabgewandten Seite des Emitters. Zum Stromabgriff an den Emitter-seitigen Kontakten sind spezielle technologische Lösungen notwendig. In der Regel arbeiten die Dielektrika-Passivierungen über den Feldeffekt dergestalt, dass eingebaute ortsfeste Ladungen generierte Minoritätsladungsträger abstoßen. (3) Es werden weitere passivierende Schichten zwischen dem dotierten aSi (als Emitter) und dem cSi als (Absorber) eingebracht. Der bekannteste Fall einer solchen passivierenden Schicht ist intrinsisches aSi (i- aSi).
Eine wesentliche Erweiterung dieses Verfahrens - immer noch bezogen auf Heterojunction-Solarzellen - besteht im Ersatz der i-aSi-Schichten durch Suboxide. Die Passivschichten werden dabei beidseitig auf dem Absorber aufgebracht. Bei ansonsten vergleichbaren Parametern wurde eine Erhöhung des Wirkungsgrades um etwa 2.5 % auf 19.5 % erhalten (T. Müller et al.: Application of Wide Band Hydrogenated Amorphous Silicon Oxide (a-SiOx:H) Layers to Heterojunction Solar Cells for High- Quality Passivation), 33rd IEEE Photovoltaic Specialists Conference, May 11-16, 2008, Sa Diego, CA. Die Verbesserung beruht im Wesentlichen auf einer Reduzierung der Oberflächenrekombinationsgeschwindigkeit auf 8 - 9 cm/sec. Die a-SiOₓ:H Schichten werden wie die intrinischen i-aSi:H-Schichten mittels plasmaunterstützter Abscheidung aus der Gasphase hergestellt, jedoch unter Zugabe von Sauerstoff oder eines Sauerstoff-haltigen Gases, z. B. CO₂.

PIVIN J C ET AL: "Exciton-erbium coupling in SiOx suboxide films prepared by combining sol-gel chemistry and ion implantation",MATERIALS SCIENCE AND ENGINEERING B, ELSEVIER SEQUOIA, LAUSANNE, CH, Bd. 97, Nr. 1, 15. Januar 2003 (2003-01-15), Seiten 13-19 offenbart ein Sol-Gel-Verfahren zur Herstellung von Silicium-Suboxid (SiOx) unter Verwendung von TEOS oder Triethoxysilan.

BELOT V ET AL: "Sol-gel route to silicon suboxides. Preparation and characterization of silicon sesquioxide",JOURNAL OF NON-CRYSTALLINE SOLIDS, NORTH-HOLLAND PHYSICS PUBLISHING. AMSTERDAM, NL, Bd. 127, Nr. 2, 1. Februar 1991 (1991-02-01), Seiten 207-214 offenbart die Sol-Gel-Synthese von Silicium-Suboxid durch Hydrolyse von Tetrachlorsilan.

JP2005178363A offenbart ein Verfahren zur Herstellung von Silicium-Suboxid (SiOx) -Filmen durch Spincoating von Polysiloxan oder Polysilazan.

T. MÜLLER ET AL.: "Application of Wide Band Hydrogenated Amorphous Silicon Oxide (a-SiOx:H) Layers to Heterojunction Solar Cells for High- Quality Passivation",33RD IEEE PHOTOVOLTAIC SPECIALISTS CONFERENCE, 11. Mai 2008 offenbart die Passivierung von FZ-Si-Schichten durch einen hydrierten amorphen PECVD Silicium-Suboxidfilm.

US7314513B1 offenbart ein Verfahren zur Herstellung von amorphen oder polykristallinen Silicium Schichten mit Spincoating von Polysilan, gefolgt von Tempern und / oder UV-Bestrahlung.

In EP 1087 433 wird beschrieben, dass ein Polysilanfilm auf ein Substrat aufgebracht wird und durch sofortige thermische Behandlung an Luft und weiterer Behandlung mit O₂ und/oder Ozon (O₃) eine SiO₂-Schicht erhalten werden kann. Diese Schicht zeigt dann geeignete Eigenschaften als Dielektrikum in elektronischen Bauteilen. In US 2004/0248429 wird beschrieben, dass ein Polysilanfilm auf ein Substrat aufgebracht und durch sofortiges Aussetzen des Films mit O₂ und/oder O₃ und weitere thermische Behandlung unter Inertbedingungen der Polysilanfilm in eine Si-Schicht mit einer SiO₂ Oberfläche bestimmter Dicke konvertiert wird. Eine SiO₂-Schicht ist jedoch nachteilig für optoelektronische Anwendungen, da sie als Barriereschicht dient.

Aufgabe der vorliegenden Erfindung war es nun, ein Verfahren mit geringem technischen Aufwand bereit zu stellen, das die Herstellung halbleitender oder leitender Schichten aus Flüssigsilan-Formulierungen und die Modifizierung der Oberflächen bzw. Grenzflächen gestattet, so dass Störstellen beseitigt oder verringert werden und eine genügend hohe Effizienz, z. B. bei daraus hergestellten Solarzellen, erreicht wird.

Überraschend werden oben beschriebene Schwierigkeiten behoben oder verringert, indem man entweder die Oberfläche des aus Flüssigsilan-Formulierungen gebildeten Siliziums mit Sauerstoff oder geeigneten sauerstoffhaltigen Verbindungen behandelt oder Sauerstoff bzw. geeignete sauerstoffhaltige Verbindungen den Flüssigsilan-Formulierungen zusetzt. Im Fall der Folge von Silizium p- und n- Schichten, werden auf diese Weise Störstellen verringert, so dass ein ipini- oder inipi- Übergang bzw. ein pin- oder nip-Übergang vorliegt, der die Herstellung einer Solarzelle mit erhöhtem Wirkungsgrad ermöglicht.

Der Grundgedanke der Erfindung besteht also darin, eine Solarzelle, die auf Basis von flüssigem Silizium hergestellt wird, an den Grenzflächen zwischen p- und i-Schichten, n- und i-Schichten und eventuell zwischen der Metallisierung und der n- bzw. p-Schicht zu passivieren. Unter "n-Schichten" und "p-Schichten" sollen Schichten mit n-Typ- bzw. p-Typ-Leitfähigkeit verstanden werden, "i-Schichten" sind undotierte (intrinsische) Schichten.

Im vorgestellten Verfahren erfolgt die Passivierung über Oberflächen- oder Zwischenflächenbedeckung der genannten aktiven Schichten mittels einer weiteren Schicht, bei deren Herstellung Sauerstoff oder Verbindungen enthaltend Sauerstoff zugesetzt wird. Solche Schichten werden hierin als undotierte (intrinsische) Suboxidschicht "i-Si(Subox)" bezeichnet.

Unter Suboxidschichten im Sinne der vorliegenden Erfindung werden Schichten der Formel SiOx (mit 0 < x < 2) verstanden. Siliziumsuboxidschichten sind in der Regel keine elektrischen Barriereschichten.
Dabei erfolgt die Herstellung der undotierten (intrinsischen) Silicium-Suboxidschichten, der undotierten (intrinsischen) Siliciumschichten sowie der n-dotierten und p-dotierten Siliciumschichten bevorzugt durch flüssige Formulierungen enthaltend mindestens eine Siliciumverbindung. Die Suboxide werden dabei durch Einbringen von sauerstoffhaltigen Verbindungen oder Sauerstoff und/oder O₃ in anderer Form in den Herstellungsprozess der Solarzelle eingefügt.

Konkret wird die oben genannte Aufgabe erfindungsgemäß gelöst durch das Verfahren von Anspruch 1.

Im Gegensatz zum Stand der Technik werden die Schritte a) bis d) und Schritt f) bzw. a') bis e'), unter Inertbedingungen durchgeführt. Dadurch wird gewährleistet, dass ein Suboxid mit geeigneten optoelektronischen Eigenschaften entsteht. Ebenfalls entscheidend ist, dass die Schritte d) und e) nicht zusammen durchgeführt werden.
Unter Inertbedingungen im Sinne der vorliegenden Erfindung wird verstanden, dass während der entsprechenden erfindungsgemäßen Verfahrensschritte der Gehalt an Sauerstoff in der Umgebung weniger als 20 ppm beträgt. Dies wird durch Einsatz entsprechender Inertgase gewährleistet. Bespiele für einsetzbare Inertgase sind Stickstoff und/oder Edelgase, wie beispielsweise Argon und Helium, oder Mischungen hieraus, die einen Gehalt Sauerstoff von weniger als 20 ppm aufweisen. Vorzugsweise werden Stickstoff, Argon oder Helium eingesetzt. Die in den Schritten (c) bis (f) bzw. (c) bis (g) gebildete überwiegend aus Silicium bestehende und zumindest teilweise polymorphe Schicht, die Suboxidstrukturen an ihrer Oberfläche aufweist, weist dabei bevorzugt eine Schichtdicke von 5 bis 3000 nm, weiter bevorzugt von 5 bis 500 nm auf. Bevorzugte Schichtdicken liegen auch im Bereich von 50 bis 300 nm und 100 bis 200 nm. Dabei weist die Suboxidstruktur-haltige Oberfläche, also die in den Schritten (e) bis (f) bzw. (e) bis (g) gebildete Schicht, bevorzugt eine Dicke von 1 bis 50 nm, weiter bevorzugt von 1bis 20 nm auf. Die in den Schritten (b') bis (d') bzw. (b') bis (e') gebildete überwiegend aus Silicium bestehende und zumindest teilweise polymorphe Schicht, die insgesamt Suboxidstrukturen aufweist, weist dabei bevorzugt eine Schichtdicke von 5 bis 100 nm, weiter bevorzugt von 5 bis 50 nm, besonders bevorzugt von 5 bis 40 nm, auf.

In einer bevorzugten Ausführungsform des erfindungsgemäßen Verfahrens erfolgt das Behandeln mit Sauerstoff in Schritt (e) durch:
(i) Begasung der Schicht mit elementarem Sauerstoff und/oder O₃, Kohlendioxid, einer oder mehreren in Gasform gebrachten sauerstoffhaltigen Verbindung(en) oder einer Gasmischung davon, oder
(ii) Aufbringen einer flüssigen Formulierung enthaltend gelösten elementaren Sauerstoff und/oder O₃, gelöstes Kohlendioxid, eine oder mehrere sauerstoffhaltigen Verbindung(en) oder eine Mischung davon auf die Schicht.

Die alternative Verfahrensführung mit den Schritten (a') bis (e') ist nicht in jedem Fall ideal, da nicht nur auf der Oberfläche Si-Suboxide entstehen, sondern auch in der Schicht insgesamt. Trotzdem kann diese Alternative zu brauchbaren oder sogar guten Ergebnissen führen. Brauchbare Ergebnisse gelten insbesondere für dünne, undotierte Siliciumschichten (Schichtdicke 40 nm oder geringer). Dagegen führt die Einführung von Si-Suboxiden in dickere undotierte Siliciumschichten (Schichtdicke 50 nm oder höher) zu weniger guten Ergebnissen. Die Einführung von Si-Suboxiden in dotierte Siliciumschichten mit n-Dotierung oder p-Dotierung zeigt in der Regel keine verbessernde Wirkung.

Das erfindungsgemäße Verfahren kann auch so betrieben werden, dass wahlweise
(i) die Schritte (c) und (d) und/oder
(ii) die Schritte (e) und (f) und/oder
(iii) die Schritte (c') und (d')
jeweils nacheinander, sich zeitlich überschneidend oder gleichzeitig durchgeführt werden.

Wie oben ersichtlich, ist das erfindungsgemäße Verfahren geeignet zur Herstellung "mindestens einer" auf einem Substrat angeordneten Siliziumschicht. Um mehrere entsprechende Siliziumschichten auf einem Substrat zu erhalten können die Verfahrensschritte (b) bis (f) bzw. (b') bis (d') mehrfach durchgeführt werden. Bei mehreren Durchgängen der Verfahrensschritte können die einzelnen Schritte unabhängig voneinander konkret ausgestaltet werden, so dass die Eigenschaften jeder Schicht individuell für den beabsichtigten Zweck eingestellt werden können. Jedoch muss mindestens einmal der Schritt e) bzw. b') dabei durchgeführt werden

Bei der unter (e) bzw. unter (b') genannten sauerstoffhaltigen Verbindung(en) handelt es sich bevorzugt um Verbindungen der allgemeinen Formel R¹R²SiR³R⁴, wobei zumindest eine der Gruppen R¹ bis R⁴ die Struktur -O-R hat, wobei R = H, eine Alkylgruppe, eine Arylgruppe oder eine Alkylarylgruppe ist.

Die Gruppen R¹ bis R⁴ der Formel R¹R²SiR³R⁴, die die Struktur-O-R nicht haben, sind bevorzugt unabhängig voneinander ausgewählt aus Wasserstoff, einer Alkylgruppe, einer Arylgruppe oder einer Alkylarylgruppe.

In einer alternativen Ausführungsform kann es sich bei der genannten Form des Sauerstoffs um H₂O, einen Alkohol, ein Diol, ein Triol, ein Aldehyd, ein Keton, eine Carbonsäure oder einen Kohlensäureester, bevorzugt ein Kohlensäureester von Diolen, handeln. Ein geeigneter Kohlensäureester ist z. B. Propylencarbonat. Solche Kohlensäureester enthalten viel Sauerstoff und können auch gut in Schritt (b') der Formulierung zugesetzt werden.

Das verwendete Substrat hat in der Regel elektrisch leitfähig zu sein. Für diesen Fall kommen auch alle geeigneten Anordnungen mit einer elektrisch leitfähigen Oberfläche in Frage. Beispielhafte Substrate bestehen etwa aus oder sind Graphit, Metall oder mit legierungsbildenden Metallen (ausser Silicium) beschichtetes Graphit. Insbesondere ist das erfindungsgemäße Verfahren für alle Substrate der Halbleiterwafer-Technologie geeignet. In Frage kommen also auch Substrate mit Oberflächen aus Metallen, Metall-Legierungen, Graphit, leitfähigen Metalloxiden, z. B. Indiumzinnoxid (ITO), leitfähigen Kohlenstoff-Verbindungen oder sonstigen leitfähigen Objekten, z. B. Metallflitter in einer Kohlenstoff-Matrix. Geeignet sind z. B. auch mit einem leitenden Material beschichtete Isolatoren wie beispielsweise Glas, Keramik, oder temperaturbeständige Kunststoffe. Die leitfähigen Beschichtungen können vollflächig oder in besonderen Fällen nur teilflächig sein. Zum Beispiel ist im Falle leitfähig beschichteter Isolatoren in der Regel darauf zu achten, dass die spätere Bedeckung des Substrates mit der Siliziumschicht flächenmäßig nicht vollständig erfolgt, damit im Falle photovoltaischer Anordnungen seitlich eine leitende Verbindung, z. B. zur Stromableitung, bestehen bleibt.

Als Substrate können prinzipiell auch Halbleiterwafer, z. B. Silicium-Wafer, oder bevorzugt Silicium-Wafer vom n-Typ oder p-Typ, in Frage kommen.
Als Substrat kann aber auch ein beschichtetes Substrat eingesetzt werden, welches bereits nach dem hier beschriebenen Verfahren hergestellt wurde. Das beschichtete Substrat kann insbesondere eine Si-Zelle und/oder eine SiGe-Zelle darstellen.

Im erfindungsgemäßen Verfahren ist die Silicium-Verbindung eine Silicium-Wasserstoff-Verbindung, vorzugsweise der allgemeinen Formel SiₙH₂ₙ₊₂ mit n= 3 bis 10, bevorzugt n=4 bis 8 oder SiₙH₂ₙ mit n= 4 bis 8, bevorzugt n=5 und 6. In Beispielen die nicht zur Erfindung gehören, ist die Silicium-Verbindung ein Silicium-Halogenid; ein Silicium-Organyl; eine oligomere Silicium-Verbindung SiₙR₂ₙ₊₂ oder SiₙR₂ₙ mit n= 8 bis 100 und R= H, Halogen, Organyl, wobei jedes R unabhängig gewählt sein kann; oder eine beliebige Mischung solcher Silicium-Verbindungen. Des Weiteren können die genannten Verbindungen teilweise oder in Gänze oligomerisiert werden, wobei Molmassen von 500 g/mol bis 10000 g/mol, bevorzugt 800 g/mol bis 5000 g/mol eingestellt werden. Des Weiteren können auch die Silicium-Verbindungen, teilweise oder in Gänze durch Bestrahlen oder thermische Behandlung oligomerisiert werden, wobei Molmassen von 500 g/mol bis 10000 g/mol, bevorzugt 800 g/mol bis 5000 g/mol, besonders bevorzugt 1000 g/mol bis 3000 g/mol, eingestellt werden können.

Silicium-Wasserstoff-Verbindungen, also Silane und Oligo- bzw. Polysilane werden eingesetzt, da diese einen hohen Silicium-Anteil bezogen auf das Molgewicht der Verbindungen aufweisen. Von den Silanen eignen sich besonders solche der allgemeinen Formel SiₙH₂ₙ₊₂ mit n = 3 bis 10, bevorzugt n = 4 bis 8, oder SiₙH₂ₙ mit n= 4 bis 8, bevorzugt n = 5 und 6, für das erfindungsgemäße Verfahren. Ganz besonders eignen sich Oligomere, die aus diesen Silanen hergestellt worden sind, wobei Molmassen von 500 g/mol bis 10000 g/mol, bevorzugt 800 g/mol bis 5000 g/mol, besonders bevorzugt 1000 g/mol bis 3000 g/mol, eingestellt werden können.
Die in den erfindungsgemäßen Verfahren verwendete Silicium-haltige Formulierung ist eine flüssige Formulierung. Diese besteht aus den vorgenannten Silicium-Verbindungen und gegebenenfalls im Gemisch mit Lösungsmitteln. Geeignete Lösungsmittel sind z. B. bei Raumtemperatur flüssige aliphatische oder aromatische Kohlenwasserstoffe sowie deren Mischungen. Beispiele sind n-Pentan, n-Hexan, n-Heptan, n-Oktan, n-Dekan,

Dodekan, Cyclohexan, Cyclooctan, Cyclodekan, Dicyclopentan, Benzol, Toluol, m-Xylol, p-Xylol, Mesitylen, Indan, Inden, Tetrahydronaphtalin, Decahydronaphtalin, Diethylether, Dipropylether, Ethylenglycoldimethylether, Ethylenglycoldiethylether, Ethylenglycolmethylethylether, Diethylenglycoldimethylether, Diethylenglycoldiethylether, Diethylenglycolmethylethylether, Tetrahydrofuran, p-Dioxan, Acetonitril, Dimethylformamid, Dimethylsulfoxid, Dichlormethan und Chloroform. Die Viskosität der Beschichtungslösung liegt bevorzugt bei 1 bis 2000 mPas.

In einer Variante des erfindungsgemäßen Verfahrens kann die Silicium-haltige Formulierung durch Oligomerisieren und/oder Polymerisieren eines Gemisches enthaltend mindestens ein höheres Silan der allgemeinen Formel SiₙH₂ₙ₊₂ mit n = 3 bis 10, bevorzugt n = 4 bis 8, oder SiₙH₂ₙ mit n= 4 bis 8, bevorzugt n = 5 und 6 hergestellt werden. Zur Oligomerisierung mittels UV-Bestrahlung oder Wärmebehandlung werden höhere Silane der vorgenannten Formeln mit n ≥ 3 eingesetzt. Auf diese Weise kann aus einer flüssigen niedrigviskosen Mischung in einem Schritt eine gewünschte höherviskose Flüssigmischung enthaltend Oligo-/Polysilane hergestellt werden.

Gegebenenfalls kann/können zusätzlich Lösungsmittel, Dotierungsmittel und/oder weitere Hilfsstoffe zugesetzt werden. Dabei können diese weiteren Mittel bzw. Stoffe unabhängig voneinander dem Gemisch bereits vor dem Oligomerisieren und/oder Polymerisieren oder erst danach zugesetzt werden. Werden den Mischungen Dotierstoffe zugesetzt, können das im Falle der n-Dotierung z. B. Phosphor-Verbindungen, wie etwa Phenylphosphin, und im Falle der p-Dotierung z. B. Bor-Verbindungen, wie etwa Dekaboran-14, sein. Auch in diesem Fall kann das Oligomerisieren und/oder Polymerisieren teilweise oder in Gänze durch Bestrahlen oder thermische Behandlung erfolgen, wobei Molmassen von 500 g/mol bis 10000 g/mol, bevorzugt 800 g/mol bis 5000 g/mol, besonders bevorzugt 1000 g/mol bis 3000 g/mol, eingestellt werden können. Der Anteil an Lösungsmittel bezogen auf die Gesamtformulierung kann 5 bis 95 Gew.-%, bevorzugt 25 bis 93 Gew.-%, besonders bevorzugt 50 bis 93 Gew.-% betragen.

Das Beschichten des Substrats mit der Silicium-haltigen Formulierung kann auf bekannte Weise erfolgen, bevorzugt durch Aufgießen oder Rakeln oder Verfahren ausgewählt aus Druck- bzw. Beschichtungsverfahren (insbesondere Flexo/Gravur-Druck, Inkjet-Druck, Offset-Druck, digitalem Offset-Druck und Siebdruck), Sprühverfahren, Rotationsbeschichtungs-verfahren ("Spin-coating"), Tauchverfahren ("Dip-coating") und Verfahren ausgewählt aus Meniscus Coating, Slit Coating, Slot-Die Coating, und Curtain Coating.
Das thermische Behandeln des beschichteten Substrats kann in einem, mehreren oder allen der Schritte (d), (d') und/oder (f) auf bekannte Weise erfolgen, wobei Schritt d) in der ersten Ausführungsform des erfindungsgemäßen Verfahrens in jedem Fall erfolgen muss. So wird das mit der Formulierung beschichtete Substrat bevorzugt auf Temperaturen von 200 bis 1000 °C, vorzugsweise 250 bis 700 °C, weiter bevorzugt 250 bis 600 °C, erhitzt. Dabei bildet sich erfindungsgemäß eine zumindest teilweise polymorphe und überwiegend aus Silicium bestehende Schicht. Im Falle frisch hergestellter Schichten kann auch mit einer UV-Lampe (z. B. Wellenlänge 254 nm, Leistung 15 Watt oder Wellenlänge 180 nm) eine vorgeschaltete Härtung durch Vernetzung erfolgen. In einer bevorzugten Ausführungsform des erfindungsgemäßen Verfahrens wird das beschichtete Substrat ohne Bestrahlung einer thermischen Behandlung zugeführt. Als Heizaggregate kommen z. B. Heizplatten, Infrarot-Felder, Rohröfen oder Muffelöfen in Frage, jeweils unter weitgehendem Ausschluss von O₂ und H₂O. bis auf die sehr kleinen, gezielt eingebrachten Sauerstoffmengen zum Erreichen der Suboxid-Schichten. Dabei darf die Gesamtsauerstoffmenge nicht so hoch sein, dass SiO₂ entsteht. Die Temperaturen reichen von 200°C bis 1000°C. Die Schichten können auch bevorzugt nachbehandelt werden durch Erhitzen unter Formiergas-Mischungen aus Wasserstoff und Stickstoff oder aus Wasserstoff und Argon (z. B. H₂/N₂ im Volumen-Verhältnis 5/95 bis 10/90 oder H₂/Ar im Volumen-Verhältnis 5/95 bis 10/90) bei Temperaturen von 250°C bis 700°C, bevorzugt 250°C bis 500°C.

Ein Beispiel das nicht zur Erfindung gehört ist ein beschichtetes Substrat, umfassend eine der folgenden Schichtabfolgen:
- Substrat // i-Si(Subox),
- Substrat // i-Si // i-Si(Subox),
- Substrat // n-Si // i-Si(Subox) // i-Si // i-Si(Subox) // p-Si,
- Substrat // p-Si // i-Si(Subox) // i-Si // i-Si(Subox) // n-Si,
- Substrat // i-Si(Subox) // n-Si // i-Si(Subox) // i-Si // i-Si(Subox) // p-Si // i-Si(Subox), und
- Substrat // i-Si(Subox) // p-Si // i-Si(Subox) // i-Si // i-Si(Subox) // n-Si // i-Si(Subox).
- Substrat // n-Si// p-Si // p-Si(Subox) // n-Si // i-Si// p-Si
- Substrat // p-Si// n-Si // n-Si(Subox) // p-Si // i-Si// n-Si
- Substrat // n-Si// i-Si // p-Si // p-Si(Subox) // n-Si // i-Si// p-Si
- Substrat // p-Si// i-Si // n-Si // n-Si(Subox) // p-Si // i-Si// n-Si

Unter "i-Si(Subox)" wird im Rahmen der Erfindung eine überwiegend aus Silicium bestehende und zumindest teilweise polymorphe, undotierte (intrinsische) Schicht verstanden, die Suboxidstrukturen an ihrer Oberfläche oder insgesamt Suboxidstrukturen aufweist.

Unter "i-Si" wird eine überwiegend aus Silicium bestehende, undotierte Schicht, vorzugsweise eine aus Silicium bestehende, undotierte Schicht verstanden. Unter "n-Si" wird eine überwiegend aus Silicium bestehende, n-Typ-dotierte Schicht und unter "p-Si" eine entsprechende p-Typ-dotierte Schicht verstanden. Das Zeichen " //" zeigt den Übergang zur jeweils nächsten Schicht an.

Bevorzugte Schichtabfolgen sind
- Substrat // i-Si // i-Si(Subox),
- Substrat // n-Si // i-Si(Subox) // i-Si // i-Si(Subox) // p-Si,
- Substrat // p-Si // i-Si(Subox) // i-Si // i-Si(Subox) // n-Si,
- Substrat // i-Si(Subox) // n-Si // i-Si(Subox) // i-Si // i-Si(Subox) // p-Si // i-Si(Subox), und
- Substrat // i-Si(Subox) // p-Si // i-Si(Subox) // i-Si // i-Si(Subox) // n-Si // i-Si(Subox).
- Substrat // n-Si// p-Si // p-Si(Subox) // n-Si // i-Si// p-Si
- Substrat // p-Si// n-Si // n-Si(Subox) // p-Si // i-Si// n-Si
- Substrat // n-Si// i-Si // p-Si // p-Si(Subox) // n-Si // i-Si// p-Si
- Substrat // p-Si// i-Si // n-Si // n-Si(Subox) // p-Si // i-Si// n-Si

Vorzugsweise werden die Suboxidschichten i-Si(Subox), p-Si(Subox) und n-Si(Subox) durch Verfahren gemäß der vorliegenden Erfindung hergestellt. Ganz besonders bevorzugt werden alle Schichten nach einem Flüssigphasenverfahren hergestellt.

Die Schichten i-Si weisen dabei bevorzugt eine Schichtdicke von 5 bis 3000 nm, weiter bevorzugt von 5 bis 500 nm auf.

Die Schichten i-Si(Subox), p-Si(Subox) und n-Si(Subox) weisen dabei bevorzugt eine Schichtdicke von 1 bis 50 nm, weiter bevorzugt von 1 bis 40 nm, besonders bevorzugt von 1 bis 20 nm, auf.

Für die in der Schrittfolge d),e) und f) gebildete Schicht, welche aus i-Si und i-Si(Subox) besteht, gilt die oben genannte bevorzugte Schichtdicke von i-Si, nämlich bevorzugt 10 bis 3000 nm, weiter bevorzugt von 20 bis 500 nm. Für den Anteil i-Si(Subox) gilt eine bevorzugte Schichtdicke von 1 bis 20 nm, weiter bevorzugt von 1 bis 15 nm, besonders bevorzugt von 1 bis 10 nm.

Die Schichten n-Si und p-Si weisen bevorzugt eine Schichtdicke von 10 bis 3000 nm, weiter bevorzugt von 20 bis 500 nm auf.

Die oben genannten beispielhaften Schichtabfolgen umfassen vorzugsweise keine weiteren Zwischenschichten innerhalb der jeweiligen Schichtabfolge. Gleichwohl können weitere Schichten, die weiter nach außen angeordnet sind, vorgesehen sein. Das verwendete Substrat kann z. B. ein mehrschichtiges Substrat sein. Auch auf die jeweils zuletzt genannte Schicht können weitere funktionale Schichten angeordnet sein. Es soll auch nicht ausgeschlossen werden, dass nicht gegebenenfalls doch weitere Zwischenschichten innerhalb der jeweiligen Schichtabfolgen vorgesehen sein können.

Nach dem erfindungsgemäßen Verfahren lassen sich die Si(Subox)-Schichten sehr vorteilhaft gegenüber der Plasma-unterstützten Abscheidung aus der Gasphase (PECVD-Verfahren) herstellen. Das bei Temperaturen von sinnvollerweise bis 300°C anwendbare PECVD-Verfahren lässt zwar auch eine gewisse Polymorphie des Siliziums bzw. der a-SiOₓ:H Schichten zu, indem man die Prozessführung über die Frequenz bei der Plasmaerzeugung und den Wasserstoffgehalt in der Gasphase variiert. Das erfindungsgemäße Verfahren erlaubt jedoch nicht nur eine einfachere Herstellung der Schichten, es ermöglicht auch eine einfachere Variation der Polymorphie alleine durch die Temperaturbehandlung der Schichten, wobei man Temperaturen bis 1000 °C anwenden kann. Diese hohe Temperaturspanne ermöglicht zudem eine verbesserte Optimierung der Si(Subox)-Schichten.

Als Substrate kommen alle oben genannten Materialien und Anordnungen in Frage.

Ein weiteres Beispiel das nicht zur Erfindung gehört ist ein photovoltaisches Gerät, insbesondere eine Solarzelle oder Solarzellenkombinationen, welches unter Anwendung desr hier beschriebenen erfindungsgemäßen Verfahrens oder seiner Varianten hergestellt wurde bzw. hergestellt werden kann.
Die vorliegende Erfindung umfasst insbesondere auch die Verwendung von Sauerstoff in Form von elementarem Sauerstoff, Kohlendioxid, einer oder mehreren sauerstoffhaltigen Verbindung(en) oder einer Mischung davon in reiner Form oder in Form einer flüssigen oder gasförmigen Mischung für Silicium-Suboxidstrukturen bei der Herstellung einer überwiegend aus Silicium bestehenden und zumindest teilweise polymorphen Schicht, wobei die Schicht die Suboxidstrukturen an ihrer Oberfläche oder insgesamt aufweist.

### Beispiele:

Die angegebenen Schichtdicke wurden mit einem Profilometer, KLA Tencor, Gerätetyp P15 der Firma KLA-Tencor Corporation, Film and Surface Technology, 160 Rio Robles, San Jose, California USA 951 34, gemessen.

### Beispiel 1: Herstellung einer undotierten Si-Schicht (i-Si-Schicht)

### 1a) Schichtdicken 100 nm bis 200 nm

In einer Glove-Box mit einer Argon-Atmosphäre, die eine Sauerstoffkonzentration unter 0,5 ppm und einen Wassergehalt von höchstens 0,5 ppm aufwies, wurden 5 g Cyclopentasilan im offenen Gefäß mit einer UV-Lampe der Wellenlänge 254 nm und einer Leistung von 15 Watt im Abstand von 6 cm während einer Zeitdauer von 15 min bestrahlt. Dabei wurde das dünnflüssige Silan dickflüssiger.

Mit Hilfe der Gelpermeationschromatograhie (GPC) wurde unter Zuhilfenahme einer Polystyrol-Eichkurve das gewichtsmittlere Molekulargewicht des höhermolekularen Anteils des dickflüssigen Silangemisches zu Mw=2400 g/mol bestimmt. Außerdem enthielt das Gemisch noch Reste von monomerem Cyclopentasilan.

Das Gemisch wurde mit Toluol so verdünnt, dass die Mischung aus 1 Gew.-Teil Silan und 3 Gew.-Teilen Toluol besteht und mit Hilfe eines Spincoaters auf ein mit Silber beschichtetes Quarzplättchen der Größe 2,5 cm · 2,5 cm aufgebracht werden konnte. Anschließend wurde mit Hilfe einer Heizplatte die Schicht auf 500 °C für die Dauer von 2 min erhitzt. Es entstand eine dunkle, im Wesentlichen sauerstofffreie undotierte Silicium-Schicht auf dem metallischen Substrat. Sie erhält die Kurzbezeichnung "i-Si". Die Schichtdicke betrug 140 nm.

### 1b) Schichtdicken von 5 nm bis 40 nm

Das unter 1a) beschriebene Vorgehen wurde wiederholt mit dem Unterschied, dass die hergestellte Mischung aus Cyclopentasilan-Oligomeren mit einem gewichtsmittleren Molekulargewicht des höhermolekularen Anteils von Mw=2400 g/mol und Resten von monomerem Cyclopentasilan nicht mit 3 Teilen Toluol, sondern mit 6 Teilen Toluol verdünnt wurde. Hierdurch wird die Schichtdicke gegenüber Beispiel 1a) verringert. Die Schichtdicke betrug 25 nm.

### Beispiel 2: Herstellung einer n-dotierten Si-Schicht (n-Si-Schicht)

Das Beispiel 1a) wurde durchgeführt, jedoch mit dem Unterschied, dass der durch UV-Bestrahlung hergestellten Mischung aus oligomerem und monomerem Cyclopentasilan beim Verdünnen zusammen mit dem Toluol ein Co-Oligomerisat von Phenylphosphin und Cyclopentasilan mit dem gewichtsmittleren Molekulargewicht Mw=2200 g/mol als Dotiermittel zugegeben wurde.

Das Gemisch wurde mit Hilfe eines Spincoaters auf ein mit Silber beschichtetes Quarzplättchen der Größe 2,5 cm · 2,5 cm aufgebracht. Anschließend wurde mit Hilfe einer Heizplatte die Schicht auf 500 °C für die Dauer von 2 min erhitzt. Es entstand eine dunkle im Wesentlichen sauerstofffreie n-dotierte Silicium-Schicht auf dem metallischen Substrat. Sie erhält die Kurzbezeichnung "n-Si". Die Schichtdicke betrug 170 nm.

### Beispiel 3: Herstellung einer p-dotierten Si-Schicht (p Si-Schicht)

Das Beispiel 1a) wurde durchgeführt, jedoch mit dem Unterschied, dass der durch UV-Bestrahlung hergestellten Mischung aus oligomerem und monomerem Cyclopentasilan beim Verdünnen zusammen mit dem Toluol ein Co-Oligomerisat von Dekaboran-14 und Cyclopentasilan mit dem gewichtmittleren Molekulargewicht Mw=2500 g/mol als Dotiermittel zugegeben wurde.

Das Gemisch wurde mit Hilfe eines Spincoaters auf ein mit Silber beschichtetes Quarzplättchen der Größe 2,5 cm · 2,5 cm aufgebracht. Anschließend wurde mit Hilfe einer Heizplatte die Schicht auf 500 °C für die Dauer von 2 min erhitzt. Es entstand eine dunkle im Wesentlichen sauerstofffreie p-dotierte Silicium-Schicht auf dem metallischen Substrat. Sie erhält die Kurzbezeichnung "p-Si". Die Schichtdicke betrug 180 nm.

### Beispiel 4: Herstellung einer einheitlichen, undotierten Si-Schicht mit Suboxid-Strukturen unter Einbringen von Sauerstoff in Schritt (b')

In einer Glove-Box mit einer Argon-Atmosphäre wurde die unter Beispiel 1a) beschriebene Herstellung einer Mischung aus oligomerem und monomerem Cyclopentasilan durch UV-Bestrahlung wiederholt. Der oligomere Anteil hatte dabei ein gewichtsmittleres Molekulargewicht M_{w} von 2500 g/mol, gemessen mittels GPC.

Die Mischung wurde zunächst mit Toluol so verdünnt, dass eine Mischung aus 1 Gew.-Teil Silan und 5 Gew.-Teilen Toluol erhalten wurde. Danach wurde 1 Gew.- Teil einer Lösung von 1 Gew.-Teil Isobutyltrimethoxysilan in 20 Gew.-Teilen Toluol zugegeben.

Das Gemisch wurde mit Hilfe eines Spincoaters auf ein mit Silber beschichtetes Quarzplättchen der Größe 2,5 cm · 2,5 cm aufgebracht. Anschließend wurde mit Hilfe einer Heizplatte die Schicht auf 500 °C für die Dauer von 2 min erhitzt. Es entstand eine dunkle, sauerstoffhaltige undotierte Silicium-Schicht auf dem metallischen Substrat, sie erhält die Kurzbezeichnung "i-Si(Subox)". Die Schichtdicke betrug 20 nm.

### Beispiel 5: Herstellung einer undotierten Si-Schicht, mit Suboxid-Strukturen an der Oberfläche, Einbringen von Sauerstoff in Schritt (e)

In einer Glove-Box mit einer Argon-Atmosphäre wurde die unter Beispiel 1 beschriebene Herstellung einer Mischung aus oligomerem und monomerem Cyclopentasilan durch UV-Bestrahlung wiederholt. Der oligomere Anteil hatte dabei ein gewichtsmittleres Molekulargewicht M_{w} von 2500 g/mol, gemessen mittels GPC.

Die Mischung wurde mit zunächst mit Toluol so verdünnt, dass die Mischung aus 1 Gew.-Teil Silan und 3 Gew.-Teilen Toluol erhalten wurde.

Das Gemisch wurde mit Hilfe eines Spincoaters auf ein mit Silber beschichtetes Quarzplättchen der Größe 2,5 cm · 2,5 cm aufgebracht. Anschließend wurde mit Hilfe einer Heizplatte die Schicht auf 280 °C für die Dauer von 30 Sekunden erhitzt. Es entstand eine dunkelorangefarbene undotierte Silicium-Precursor-Schicht auf dem metallischen Substrat.

Nach dem Abkühlen wird auf die Precursor-Schicht eine Lösung von 5 Gew.- Teilen Isobutyltrimethoxysilan in 95 Gew.-Teilen Toluol via Spincoating aufgebracht. Anschließend wurde mit Hilfe einer Heizplatte die Schicht auf 500 °C für die Dauer von 2 min erhitzt. Es entstand eine dunkle undotierte, Silicium-Schicht auf dem metallischen Substrat, welche nur an der Oberfläche suboxidische Strukturen aufweist, so dass hier bereits eine Schichtfolge aus i-Si und i-Si(Subox) vorliegt. Sie erhält die Kurzbezeichnung "i-Si // i-Si(Subox)". Die Dicke der Doppelschicht betrug insgesamt 23 nm.

### Beispiel 6: Schichtfolge zur Herstellung einer dünnschichtigen nip-Solarzelle mit Suboxid

Zuerst wurde, wie unter Beispiel 2 beschrieben, eine n-dotierte Si-Schicht = n-Si auf einem metallischen Substrat hergestellt. Die Schichtdicke betrug 350 nm.
In Abwandlungen von Beispiel 6 kann die Schichtdicke auch im Bereich zwischen 50 nm und 500 nm liegen.

Diese Anordnung diente als neues Substrat, auf dem wie unter Beispiel 4 beschrieben, eine sauerstoffhaltige undotierte Silicium-Schicht = i-Si(Subox) aufgebracht wurde. Die Schichtdicke betrug 20 nm. In Abwandlungen kann die Schichtdicke im Bereich zwischen 5 nm und 50 nm liegen.

Es folgte die Aufbringung einer undotierten Si-Schicht, mit Suboxid-Strukturen an der Oberfläche = i-Si // i-Si(Subox) wie in Beispiel 5 beschrieben. Die Schichtdicke betrug 140 nm. In Abwandlungen kann die Schichtdicke im Bereich zwischen 5 nm und 500 nm liegen.

Danach wurde, der Beschreibung in Beispiel 3 folgend, eine p-dotierte Silicium-Schicht = p-Si aufgebracht. Die Schichtdicke betrug 80 nm. In Abwandlungen kann die Schichtdicke im Bereich zwischen 20 nm und 500 nm liegen.

In Kurzform lautet die erhaltene Schichtfolge dann:
Metallsubstrat // n-Si // i-Si(Subox) // i-Si // i-Si(Subox) // p-Si

### Beispiel 7: Schichtfolge zur Herstellung einer dünnschichtigen pin-Solarzelle mit Suboxid

Zuerst wurde, wie unter Beispiel 3 beschrieben, eine p-dotierte Si-Schicht = p-Si auf einem metallischen Substrat hergestellt. Die Schichtdicke betrug 400 nm. In Abwandlungen von Beispiel 7 kann die Schichtdicke im Bereich zwischen 50 nm und 500 nm liegen.

Diese Anordnung diente als neues Substrat, auf dem wie unter Beispiel 4 beschrieben, eine sauerstoffhaltige undotierte Silicium-Schicht = i-Si(Subox) aufgebracht wurde. Die Schichtdicke betrug 25 nm. In Abwandlungen kann die Schichtdicke im Bereich zwischen 5 nm und 50 nm liegen.

Es folgt die Aufbringung einer undotierten Si-Schicht, mit Suboxid-Strukturen an der Oberfläche = i-Si // i-Si(Subox) wie in Beispiel 5 beschrieben. Die Schichtdicke betrug 120 nm. In Abwandlungen kann die Schichtdicke im Bereich zwischen 5 nm und 50 nm liegen.

Danach wurde, der Beschreibung in Beispiel 2 folgend, eine n-dotierte Silicium-Schicht = n-Si aufgebracht. Die Schichtdicke betrug 70 nm. In Abwandlungen kann die Schichtdicke im Bereich zwischen 20 nm und 500 nm liegen.

In Kurzform lautet die erhaltene Schichtfolge dann:
Metallsubstrat // p-Si // i-Si(Subox) // i-Si // i-Si(Subox) // n-Si

### Beispiel 8: Schichtfolge zur Herstellung einer dünnschichtigen inipi-Solarzelle mit Suboxid

Es wurde wie in Beispiel 6 vorgegangen, wobei zusätzlich als erster Schritt auf dem Metallsubstrat eine i-Si(Subox) Schicht gemäß Beispiel 4 aufgebracht wurde und weiterhin zusätzlich als letzter Schritt ebenfalls eine i-Si(Subox) Schicht gemäß Beispiel 4 appliziert wurde.

In Kurzform lautet die erhaltene Schichtfolge dann:
Metallsubstrat // i-Si(Subox) // n-Si // i-Si(Subox) // i-Si // i-Si(Subox) // p-Si // i-Si(Subox)

### Beispiel 9: Schichtfolge zur Herstellung einer dünnschichtigen ipini-Solarzelle mit Suboxid

Es wurde wie in Beispiel 6 vorgegangen, wobei zusätzlich als erster Schritt auf dem Metallsubstrat eine i-Si(Subox) Schicht gemäß Beispiel 4 aufgebracht wurde und weiterhin zusätzlich als letzter Schritt ebenfalls eine i-Si(Subox) Schicht gemäß Beispiel 4 appliziert wurde.

In Kurzform lautet die erhaltene Schichtfolge dann:
Metallsubstrat // i-Si(Subox) // p-Si // i-Si(Subox) // i-Si // i-Si(Subox) // n-Si // i-Si(Subox)

## Patentansprüche

1. Verfahren zur Herstellung mindestens einer auf einem Substrat angeordneten Siliziumschicht, wobei mindestens eine der Siliciumschichten Suboxidstrukturen an ihrer Oberfläche oder insgesamt Suboxidstrukturen aufweist, umfassend die Schritte:
(a) Bereitstellen eines Substrates,
(b) Bereitstellen einer flüssigen Formulierung enthaltend mindestens eine Silicium-Verbindung, deren die Viskosität bei 1 bis 2000 mPas liegt,
(c) Aufbringen der Formulierung auf das Substrat,
(d) Bestrahlen und/oder thermisches Behandeln des beschichteten Substrats,
(e) Behandeln der nach Schritt (d) erhaltenen Schicht mit Sauerstoff in Form von elementarem Sauerstoff und/oder O₃, Kohlendioxid, einer oder mehreren sauerstoffhaltigen Verbindung(en) oder einer Mischung davon in reiner Form oder in Form einer flüssigen oder gasförmigen Mischung, und
(f) Bestrahlen und/oder thermisches Behandeln des nach Schritt (e) erhaltenen beschichteten Substrats,
wobei die Schritte a) bis d) und Schritt f) unter Inertbedingungen mit einem Gehalt an Sauerstoff in der Umgebung von weniger als 20 ppm stattfinden, und wobei die Schritte d) und e) nicht zusammen durchgeführt werden, unter Bildung einer überwiegend aus Silicium bestehenden und zumindest teilweise polymorphen Schicht, die Suboxidstrukturen an ihrer Oberfläche aufweist,
oder umfassend die Schritte:
(a') Bereitstellen eines Substrates,
(b') Bereitstellen einer flüssigen Formulierung enthaltend mindestens eine Silicium-Verbindung, deren die Viskosität bei 1 bis 2000 mPas liegt, und enthaltend Sauerstoff in Form von elementarem Sauerstoff und/oder O₃, Kohlendioxid, einer oder mehreren sauerstoffhaltigen Verbindung(en) oder einer Mischung davon in reiner Form oder in Form einer flüssigen oder gasförmigen Mischung,
(c') Aufbringen der Formulierung auf das Substrat, und
(d') Bestrahlen und/oder thermisches Behandeln des nach Schritt (c') erhaltenen beschichteten Substrats,
wobei die Schritte (a') bis (d') unter Inertbedingungen mit einem Gehalt an Sauerstoff in der Umgebung von weniger als 20 ppm stattfinden, unter Bildung einer überwiegend aus Silicium bestehenden und zumindest teilweise polymorphen Schicht, die insgesamt Suboxidstrukturen aufweist, wobei
in einem, mehreren oder allen der Schritte (d), (d') und (f) die thermische Behandlung bei Temperaturen von 200 bis 1000 °C durchgeführt wird, und
die Silicium-Verbindung eine Silicium-Wasserstoff-Verbindung ist.

2. Verfahren nach Anspruch 1, **dadurch gekennzeichnet, dass** in Schritt (e) das Behandeln mit Sauerstoff erfolgt durch:
i) Begasung der Schicht mit elementarem Sauerstoff und/oder O₃, Kohlendioxid, einer oder mehreren in Gasform gebrachten sauerstoffhaltigen Verbindung(en) oder einer Gasmischung davon, oder
ii) Aufbringen einer flüssigen Formulierung enthaltend gelösten elementaren Sauerstoff und/oder O₃, gelöstes Kohlendioxid, eine oder mehrere sauerstoffhaltigen Verbindung(en) oder eine Mischung davon auf die Schicht.

3. Verfahren nach einem der vorherigen Ansprüche, **dadurch gekennzeichnet, dass** die Schritte (b) bis (f) und/oder (b') bis (d') mehrfach durchgeführt werden.

4. Verfahren nach einem der vorherigen Ansprüche, **dadurch gekennzeichnet, dass** es sich bei der Form des Sauerstoffs um H₂O, einen Alkohol, ein Diol, ein Triol, ein Aldehyd, ein Keton, eine Carbonsäure, einen Kohlensäureester oder um eine sauerstoffhaltige Verbindung der allgemeinen Formel R¹R²SiR³R⁴ handelt, wobei zumindest eine der Gruppen R¹ bis R⁴ die Struktur -O-R hat, wobei R = H, eine Alkylgruppe, eine Arylgruppe oder eine Alkylarylgruppe ist.

5. Verfahren nach einem der vorherigen Ansprüche, **dadurch gekennzeichnet, dass** das Substrat elektrisch leitfähig ist oder eine elektrisch leitfähige Oberfläche aufweist.

6. Verfahren nach einem der vorherigen Ansprüche, **dadurch gekennzeichnet, dass** die Silicium-Wasserstoff-Verbindung eine Verbindung der allgemeinen Formel SiₙH₂ₙ₊₂ mit n = 3 bis 10 oder SiₙH₂ₙ mit n = 4 bis 8, oder eine beliebige Mischung solcher Silicium-Verbindungen ist.

7. Verfahren nach einem der vorherigen Ansprüche, **dadurch gekennzeichnet, dass** die Beschichtung des Substrats mittels Aufgießen oder Rakeln oder Verfahren ausgewählt aus Druck- bzw. Beschichtungsverfahren, Sprühverfahren, Rotationsbeschichtungs-verfahren, Tauchverfahren und Verfahren ausgewählt aus Meniscus Coating, Slit Coating, Slot-Die Coating, und Curtain Coating erfolgt.

8. Verfahren nach einem der vorherigen Ansprüche, **dadurch gekennzeichnet, dass** in einem, mehreren oder allen der Schritte (d), (d') und(f) die thermische Behandlung bei Temperaturen von 250 bis 700 °C, bevorzugt 250 bis 500 °C durchgeführt wird.

## Claims

1. Process for preparing at least one silicon layer arranged on a substrate, at least one of the silicon layers having suboxide structures on the surface thereof or suboxide structures throughout, comprising the steps of:
(a) providing a substrate,
(b) providing a liquid formulation containing at least one silicon compound, the viscosity of which is 1 to 2000 mPas,
(c) applying the formulation to the substrate,
(d) irradiating and/or thermally treating the coated substrate,
(e) treating the layer obtained after step (d) with oxygen in the form of elemental oxygen and/or O₃, carbon dioxide, one or more oxygen compound(s) or a mixture thereof in pure form or in the form of a liquid or gaseous mixture, and
(f) irradiating and/or thermally treating the coated substrate obtained after step (e),
wherein steps a) to d) and step f) take place under inert conditions with a content of oxygen in the environment of less than 20 ppm, and wherein steps d) and e) are not conducted together,
to form an at least partly polymorphic layer which consists predominantly of silicon and has suboxide structures on its surface,
or comprising the steps of:
(a') providing a substrate,
(b') providing a liquid formulation containing at least one silicon compound, the viscosity of which is 1 to 2000 mPas, and containing oxygen in the form of elemental oxygen and/or O₃, carbon dioxide, one or more oxygen compound(s) or a mixture thereof in pure form or in the form of a liquid or gaseous mixture,
(c') applying the formulation to the substrate, and
(d') irradiating and/or thermally treating the coated substrate obtained after step (c'),
wherein steps (a') to (d') take place under inert conditions with a content of oxygen in the environment of less than 20 ppm,
to form an at least partly polymorphic layer which consists predominantly of silicon and has suboxide structures throughout, wherein the thermal treatment in one, more than one or all of steps (d), (d') and (f) is conducted at temperatures of 200 to 1000°C, and
the silicon compound is a silicon-hydrogen compound.

2. Process according to Claim 1, **characterized in that** the treatment with oxygen in step (e) is effected by:
i) contacting the layer with gaseous elemental oxygen and/or O₃, carbon dioxide, one or more oxygen compound(s) converted to gaseous form or a gas mixture thereof, or
ii) applying a liquid formulation comprising dissolved elemental oxygen and/or O₃, dissolved carbon dioxide, one or more oxygen compound(s) or a mixture thereof to the layer.

3. Process according to either of the preceding claims, **characterized in that** steps (b) to (f) and/or (b') to (d') are conducted more than once.

4. Process according to any one of the preceding claims, **characterized in that** the oxygen takes the form of H₂O, an alcohol, a diol, a triol, an aldehyde, a ketone, a carboxylic acid, a carbonic ester or an oxygen compound of the general formula R¹R²SiR³R⁴ where at least one of the R¹ to R⁴ groups has the structure -O-R where R = H, an alkyl group, an aryl group or an alkylaryl group.

5. Process according to any one of the preceding claims, **characterized in that** the substrate is electrically conductive or has an electrically conductive surface.

6. Process according to any one of the preceding claims, **characterized in that** the silicon-hydrogen compound is a compound of the general formula SiₙH₂ₙ₊₂ where n= 3 to 10 or SiₙH₂ₙ where n= 4 to 8, or any desired mixture of such silicon compounds.

7. Process according to any one of the preceding claims, **characterized in that** the substrate is coated by means of casting or knife-coating or processes selected from printing or coating processes, spraying processes, rotary coating processes, dipping processes, and processes selected from meniscus coating, slit coating, slot-die coating and curtain coating.

8. Process according to any one of the preceding claims, **characterized in that** the thermal treatment in one, more than one or all of steps (d), (d') and (f) is conducted at temperatures of 250 to 700°C, preferably 250 to 500°C.

## Revendications

1. Procédé de fabrication d'au moins une couche de silicium agencée sur un substrat, au moins une des couches de silicium comprenant des structures de sous-oxyde sur sa surface ou comprenant des structures de sous-oxyde dans son ensemble, comprenant les étapes suivantes :
(a) la préparation d'un substrat,
(b) la préparation d'une formulation liquide contenant au moins un composé de silicium, dont la viscosité est de 1 à 2 000 mPas,
(c) l'application de la formulation sur le substrat,
(d) l'exposition à un rayonnement et/ou le traitement thermique du substrat revêtu,
(e) le traitement de la couche obtenue selon l'étape (d) avec de l'oxygène sous la forme d'oxygène élémentaire et/ou d'O₃, de dioxyde de carbone, d'un ou de plusieurs composés oxygénés ou d'un mélange de ceux-ci sous forme pure ou sous la forme d'un mélange liquide ou gazeux, et
(f) l'exposition à un rayonnement et/ou le traitement thermique du substrat revêtu obtenu selon l'étape (e), les étapes a) à d) et l'étape f) ayant lieu en conditions inertes avec une teneur en oxygène dans l'environnement inférieure à 20 ppm, et les étapes d) et e) n'étant pas réalisées ensemble,
avec formation d'une couche essentiellement constituée de silicium et au moins partiellement polymorphe, qui comprend des structures de sous-oxyde sur sa surface,
ou comprenant les étapes suivantes :
(a') la préparation d'un substrat,
(b') la préparation d'une formulation liquide contenant au moins un composé de silicium, dont la viscosité est de 1 à 2 000 mPas, et contenant de l'oxygène sous la forme d'oxygène élémentaire et/ou d'O₃, de dioxyde de carbone, d'un ou de plusieurs composés oxygénés ou d'un mélange de ceux-ci sous forme pure ou sous la forme d'un mélange liquide ou gazeux,
(c') l'application de la formulation sur le substrat, et
(d') l'exposition à un rayonnement et/ou le traitement thermique du substrat revêtu obtenu selon l'étape (c'), les étapes (a') à (d') ayant lieu en conditions inertes avec une teneur en oxygène dans l'environnement inférieure à 20 ppm,
avec formation d'une couche essentiellement constituée de silicium et au moins partiellement polymorphe, qui comprend des structures de sous-oxyde dans son ensemble, dans une, plusieurs ou toutes les étapes (d), (d') et (f), le traitement thermique étant réalisé à des températures de 200 à 1 000 °C, et
le composé de silicium étant un composé de silicium-hydrogène.

2. Procédé selon la revendication 1, **caractérisé en ce qu'**à l'étape (e), le traitement avec de l'oxygène a lieu par :
i) gazage de la couche avec de l'oxygène élémentaire et/ou O₃, du dioxyde de carbone, un ou plusieurs composés oxygénés mis sous forme gazeuse ou un mélange gazeux de ceux-ci, ou
ii) application d'une formulation liquide contenant de l'oxygène élémentaire dissous et/ou O₃, du dioxyde de carbone dissous, un ou plusieurs composés oxygénés ou un mélange de ceux-ci sur la couche.

3. Procédé selon l'une quelconque des revendications précédentes, **caractérisé en ce que** les étapes (b) à (f) et/ou (b') à (d') sont réalisées à plusieurs reprises.

4. Procédé selon l'une quelconque des revendications précédentes, **caractérisé en ce que** la forme de l'oxygène consiste en H₂O, un alcool, un diol, un triol, un aldéhyde, une cétone, un acide carboxylique, un ester d'acide carbonique ou un composé oxygéné de formule générale R¹R²SiR³R⁴, au moins un des groupes R¹ à R⁴ ayant la structure -O-R, avec R = H, un groupe alkyle, un groupe aryle ou un groupe alkylaryle.

5. Procédé selon l'une quelconque des revendications précédentes, **caractérisé en ce que** le substrat est électriquement conducteur ou présente une surface électriquement conductrice.

6. Procédé selon l'une quelconque des revendications précédentes, **caractérisé en ce que** le composé de silicium-hydrogène est un composé de formule générale SiₙH₂ₙ₊₂ avec n = 3 à 10 ou SiₙH₂ₙ avec n = 4 à 8, ou un mélange quelconque de tels composés de silicium.

7. Procédé selon l'une quelconque des revendications précédentes, **caractérisé en ce que** le revêtement du substrat a lieu par coulée ou raclage ou un procédé choisi parmi les procédés d'impression et de revêtement, les procédés de pulvérisation, les procédés de revêtement par rotation, les procédés d'immersion et les procédés choisis parmi le revêtement au ménisque, le revêtement par une fente, le revêtement par une filière et le couchage au rideau.

8. Procédé selon l'une quelconque des revendications précédentes, **caractérisé en ce que**, dans une, plusieurs ou toutes les étapes (d), (d') et (f), le traitement thermique est réalisé à des températures de 250 à 700 °C, de préférence de 250 à 500 °C.
